Europäisches Patentamt

European Patent Office

Office européen des brevets

(19)

(11) Veröffentlichungsnummer: **0 217 230**
**B1**

(12) **EUROPÄISCHE PATENTSCHRIFT**

(45) Veröffentlichungstag der Patentschrift:
21.03.90

(21) Anmeldenummer: 86112818.9

(22) Anmeldetag: 17.09.86

(51) Int. Cl.⁴: **G03G 15/10**
// G03D3/10

(54) Entwicklungsstation einer Verarbeitungsanlage für Druckplatten.

(30) Priorität: 25.09.85 DE 3534099

(43) Veröffentlichungstag der Anmeldung:
08.04.87 Patentblatt 87/15

(45) Bekanntmachung des Hinweises auf die Patenterteilung:
21.03.90 Patentblatt 90/12

(84) Benannte Vertragsstaaten:
DE FR GB IT SE

(56) Entgegenhaltungen:
AT-B- 335 839
DE-B- 2 507 221
GB-A- 1 256 719
GB-A- 2 115 180

(73) Patentinhaber: HOECHST AKTIENGESELLSCHAFT,
Postfach 80 03 20, D-6230 Frankfurt am Main 80(DE)

(72) Erfinder: Schörnig, Eberhard, Dipl.-Ing., Römerstrasse 9,
D-6204 Taunusstein 4(DE)
Erfinder: Stein, Eckehard, Dipl.-Ing., Geisenheimer
Strasse 96, D-6000 Frankfurt/Main 71(DE)
Erfinder: Düdder, Ulrich, Kaermark 60,
Dk-2650 Hvidovre(DK)

ACTORUM AG

**Beschreibung**

Die Erfindung betrifft eine Entwicklungsstation einer Verarbeitungsanlage für Druckplatten, mit zumindest einem Ausreibelement und einer Gegenwalze, sowie in Durchlaufrichtung der Druckplatten dem Ausreibelement nachgeordneten Transportwalzen.

Druckplattenverarbeitungsanlagen, insbesondere für negativ arbeitende Druckplatten, weisen in den Entwicklungsstationen Ausreibelemente auf, die das Ablösen der durch die Entwicklung nicht gehärteten Schichtanteile der Druckplatte mechanisch unterstützen. Der Einsatz von Ausreibelementen ermöglicht eine wesentliche Erhöhung der Durchlaufgeschwindigkeit der Druckplatten durch die Verarbeitungsanlage.

Aus der DE-B 25 07 221 ist eine Entwicklungsvorrichtung für Druckplatten bekannt, die ein Einlaufwalzenpaar zum Aufbringen einer Tonerdispersion auf das Ladungsbild auf der Druckplatte aufweist, des weiteren eine Verteilerwalze zum gleichmäßigen Verteilen der Tonerdispersion auf dem Ladungsbild mit einem Walzenkern aus Metall und einer aus weichem, porösem, nicht leitendem Material bestehenden Oberfläche, die mit der Druckplatte während deren Durchgang durch die Entwicklungszone in Kontakt steht. Ferner ist ein Abquetschwalzenpaar zum Entfernen der nicht verbrauchten Tonerdispersion, die in einer Auffangwanne gesammelt und zu dem Einlaufwalzenpaar zurückgeführt wird, vorhanden.

Aus der DE-A 23 31 253 ist eine Entwicklungsvorrichtung für elektrofotografische Kopiermaterialien bekannt, die in einer Entwicklungszone unter Antragswalzen vorbeigeführt werden, die von oben mit einer Tonerdispersion benetzt werden. Am Ende der Entwicklungszone befindet sich ein Paar Abquetschwalzen, das die überschüssige Tonerdispersion von der Oberfläche des Kopiermaterials durch Abquetschen entfernt.

Bei den Ausreibelementen, die in der Praxis in jeder Entwicklungsstation für Druckplatten eingesetzt werden, handelt es sich überwiegend um Bürsten- bzw. Plüschwalzen, die aus einem Metallkern mit einem entsprechenden Borsten- bzw. Plüschbesatz bestehen. Anstelle von Bürstenwalzen können auch Ausreibelemente in Form von in Querrichtung zu der durchlaufenden Druckplatte hin- und herbewegten Balken verwendet werden, deren Ausreibfläche mit Plüsch und/oder Borsten bedeckt sind. Der Antrieb der Ausreibelemente erfolgt somit entweder rotierend im Fall von Bürstenwalzen, die auch noch eine hin- und hergehende Bewegung ausführen können oder oszillierend, bei Verwendung von Ausreibbalken.

Wegen des relativ einfachen konstruktiven Aufwands und der einfachen Justage werden in der Praxis meistens rotierende Ausreibelemente, d.h. Bürstenwalzen eingesetzt. Die Bürstenwalzen laufen dabei in Plattendurchlaufrichtung um, wodurch insbesondere bei geringen Druckplattenstärken ein Plattenstau an den Bürstenwalzen verhindert wird, der bei einem Drehsinn der Bürstenwalzen entgegengesetzt zur Plattendurchlaufrichtung nicht vermeidbar ist.

Dem Ausreibelement liegt entweder eine Gegenwalze als Gegenlager oder eine Leitfläche für die Druckplatte in Form einer Tischkonstruktion gegenüber. Der Spalt zwischen dem Ausreibelement und dem Gegenlager kann dann im allgemeinen durch vertikales Verstellen des Ausreibelements festgelegt werden.

Bei den bekannten Entwicklungsstationen verläuft jeweils die Durchlaufebene der Druckplatte horizontal von dem Spalt zwischen der Bürstenwalze und deren Gegenlager durch den Spalt des Transportwalzenpaares bzw. die Spalte der Transportwalzenpaare, die am Ende der Entwicklungsstation angeordnet sind und die entwickelte Druckplatte in eine weitere Verarbeitungsstation transportieren.

Bei beiden Gegenlagerarten für die Bürstenwalze, ob es sich hierbei um eine Gegenwalze oder um eine Leitfläche in Tischform als Auflagefläche für die Druckplatte handelt, kommt es zu einem Hochschlagen der Plattenhinterkante, wenn diese das Ausreibelement passiert hat. Insbesondere bei geringen Plattenstärken führt dieses Hochschlagen häufig zur Deformation und damit zur Unbrauchbarkeit der Druckplatte. Dieser Effekt wird durch hohe Borstensteifigkeit des Bürstenbelags, hohe Bürstenwalzendrehgeschwindigkeit und steigenden Andruck des Ausreibelements begünstigt.

In der Praxis führt der Versuch, diesen Effekt zu eliminieren, zu Kompromißlösungen zwischen den einzelnen Parametern, wie Borstensteifigkeit und Bürstenwalzendrehgeschwindigkeit, sowie Anpreßdruck der Bürstenwalze oder zum Einbau von speziellen Niederhaltern, die ein Hochschlagen der Plattenhinterkante weitgehend minimieren. Zur vollständigen Vermeidung des Hochschlagens der Plattenhinterkante werden immer häufiger Verarbeitungsanlagen mit reversierenden Bürsten-/Plüschwalzen eingesetzt. Der reversierende Betrieb dieser Ausreibelemente besitzt jedoch einen gravierenden Mangel, da derartige Verarbeitungsanlagen nicht kontinuierlich mit Druckplatten beschickt werden können. Um eine weitere Druckplatte in eine derartige Verarbeitungsanlage einführen zu können, muß jeweils die zuvor eingegebene Druckplatte das bzw. die Ausreibelemente passiert haben und der Drehsinn der Ausreibelemente geändert sein, da es ansonsten zu einem Plattenstau am ersten Ausreibelement käme. Dadurch ergeben sich erhebliche Totzeiten bei der kontinuierlichen Verarbeitung der Druckplatten und eine dadurch bedingte Verringerung des Druckplattendurchsatzes der Verarbeitungsanlage.

Aufgabe der Erfindung ist es, eine Entwicklungsstation einer Verarbeitungsanlage für Druckplatten der eingangs beschriebenen Art so zu verbessern, daß ein Hochschlagen der Hinterkante der Druckplatte nach dem Passieren des Ausreibelements bzw. der Ausreibelemente weitgehend vermieden wird.

Diese Aufgabe wird erfindungsgemäß dadurch gelöst, daß das Ausreibelement gegenüber der Gegenwalze in der Durchlaufebene der Druckplatten um einen vorgegebenen Abstand a in Durchlaufrichtung versetzt ist.

In Ausgestaltung der Erfindung verläuft die Durchlaufebene horizontal durch den Spalt zwischen dem Ausreibelement und der Gegenwalze und durch den Spalt zwischen den Transportwalzen. In zweckmäßiger Weise ist das Ausreibelement eine Bürstenwalze, sind die Mittelpunkte der Bürstenwalze und der Gegenwalze um den Abstand a in Horizontalrichtung gegeneinander versetzt und berühren die Bürstenwalze und die Gegenwalze einander. Der Abstand a beträgt dabei zwei bis acht Millimeter und richtet sich nach der Plattenstärke der zu verarbeitenden Druckplatten.

In einer erfindungsgemäßen Ausführungsform ist bei einem Außendurchmesser der Bürstenwalze von 70mm, einer freien Borstenlänge von 10mm und einem Außendurchmesser von 60 mm der Gegenwalze der Abstand a gleich 4 mm.

In weiterer Ausgestaltung der Erfindung sind die Transportwalzen gegenüber der Durchlaufebene, die horizontal zwischen dem Ausreibelement und der Gegenwalze verläuft, vertikal abgesenkt. Dabei beträgt die Absenkung b der Transportwalzen zwei bis vier Millimeter.

Die Erfindung wird anhand von schematischen Zeichnungen der Anordnung von Ausreibelement und Gegenwalze sowie den Transportwalzen zueinander näher beschrieben.

Es zeigen:

Fig. 1 in schematischer Seitenansicht die Anordnung von Bürstenwalze, Gegenwalze und Transportwalzen im Stand der Technik,

Fig. 2 in schematischer Seitenansicht die Anordnung von Bürstenwalze, Gegenwalze und Transportwalzen nach einer ersten Ausführungsform der Erfindung, und

Fig. 3 in schematischer Seitenansicht die Anordnung von Bürstenwalze, Gegenwalze und Transportwalzen gemäß einer zweiten Ausführungsform der Erfindung.

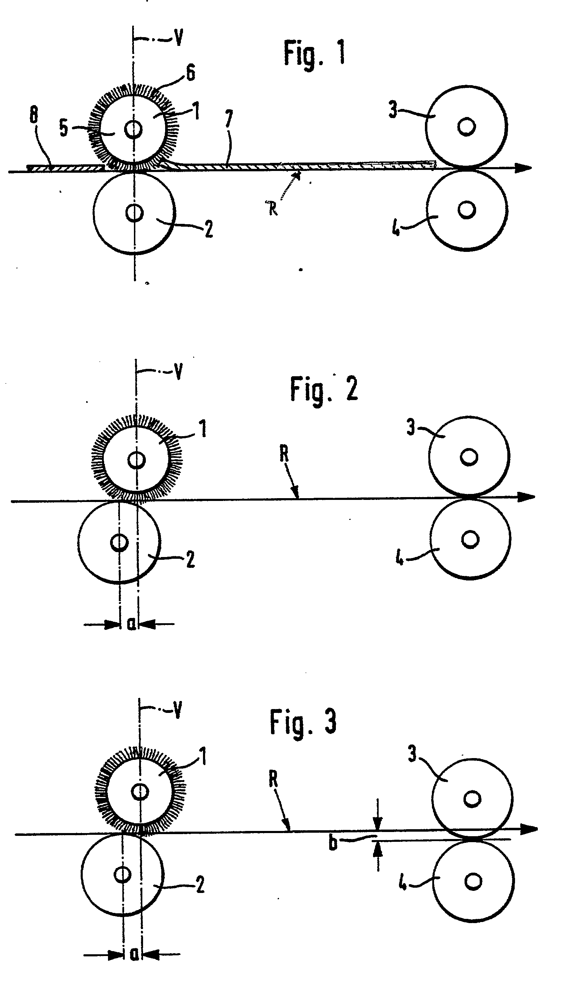

In Fig. 1 ist der Stand der Technik einer Entwicklungsstation schematisch dargestellt, die eine Bürstenwalze 1 und eine Gegenwalze 2, sowie eine oder mehrere Transportwalzenpaare enthält, von denen das eine Transportwalzenpaar mit den Walzen 3 und 4 dargestellt ist. Anstelle einer Bürstenwalze kann auch eine Plüschwalze als Ausreibelement eingesetzt sein. Die Gegenwalze 2, die als Gegenlager zu der Bürstenwalze 1 dient, ist im allgemeinen eine Stahlwalze. Die Bürstenwalze 1 besteht aus einem Metall- bzw. Stahlkern 5, auf dessen Umfangsfläche die Borsten 6 angeordnet sind, die in ihrer Gesamtheit die Bürstenoberfläche der Bürstenwalze bilden. Eine Durchlaufebene R verläuft horizontal durch den Spalt zwischen der Bürstenwalze 1 und der Gegenwalze 2 sowie den Spalt zwischen den Transportwalzen 3 und 4. Die Mittelpunkte der Bürstenwalze 1 und der Gegenwalze 2 liegen auf einer gemeinsamen vertikalen Verbindungslinie V, die mit der Durchlaufebene R einen rechten Winkel bildet. In Fig. 1 ist eine Druckplatte 7 gezeigt, die gerade die Bürstenwalze 1 und die Gegenwalze 2 passiert hat und deren Hinterkante hochschlägt. Eine weitere Druckplatte 8 wird dem Spalt zwischen der Bürstenwalze 1 und der Gegenwalze 2 zugeführt.

Anstelle der Gegenwalze 2 kann auch ein nicht dargestelltes horizontal verlaufendes Leitblech als Gegenlager zu der Bürstenwalze 1 vorgesehen werden. Die Bürstenwalze 1 ist in Vertikalrichtung innerhalb kurzer Abstände verschiebbar, um so die Spaltbreite zwischen der Bürstenwalze 1 und dem Gegenlager entsprechend der Plattendicke einstellen zu können.

In Fig. 2 ist eine Anordnung aus Bürstenwalze 1, Gegenwalze 2 und Transportwalzen 3 und 4, ähnlich zu der Anordnung nach Fig. 1 dargestellt, mit dem Unterschied, daß die Mittelpunkte der Bürstenwalze 1 und der Gegenwalze 2 um einen Abstand a in horizontaler Richtung gegeneinander versetzt sind. Dabei zeigt sich überraschenderweise, daß das Hochschlagen der Hinterkante der Druckplatte bei dieser Anordnung mit großer Sicherheit vermieden wird. Die Bürstenwalze 1 und die Gegenwalze 2 berühren sich bei dieser Anordnung. Eine gemeinsame vertikale Verbindungslinie der Mittelpunkte der Bürstenwalze 1 und der Gegenwalze 2 existiert nicht. Die Position der Gegenwalze 2 ist gegenüber der Bürstenwalze 1 um den Abstand a in Richtung Platteneinlauf vorverlegt. Bei einem speziellen Ausführungsbeispiel der Erfindung beträgt der Außendurchmesser der Bürstenwalze 70 mm, die freie Borstenlänge der Bürstenwalze 10 mm und der Außendurchmesser der Gegenwalze 60 mm. Der Abstand a liegt innerhalb eines Bereichs von 2 bis 8 mm, insbesondere wird ein Abstand a von 4 mm bevorzugt.

Der Abstand a ist als Variable einzustufen, die durch die geometrischen Abmessungen der Bürstenwalze 1 und der Gegenwalze 2 bestimmt wird. Durch eine derartige Anordnung wird das Hochschlagen der Plattenhinterkante für Druckplattenstärken zwischen 0,1 bis 0,5 mm vollständig unterdrückt.

Der durch die Versetzung der Gegenwalze 2 gegenüber der Bürstenwalze 1 auftretende positive Effekt für den Durchlauf der Druckplatten, die nunmehr von den Transportwalzen sehr gleichmäßig und ruhig weiterbefördert werden können, da ein Hochschlagen der Druckplattenhinterkante nicht auftritt, ist auf die frühere Freigabe der Plattenhinterkante durch die Bürstenwalze 1 im Vergleich zu der bekannten Anordnung nach Fig. 1 zurückzuführen. Aus der früheren Freigabe der Plattenhinterkante resultiert ein vorzeitiges Absinken der Hinterkante aus dem Einflußbereich der Bürstenwalze 1 infolge des Eigengewichts der Druckplatte und des auf ihr befindlichen Entwicklergewichtes. Das letztere kann sich besonders bei geringen Plattenstärken bemerkbar machen. Als weitere Einflußgröße ist auch die Änderung des Eingriffzeitpunktes der Bürstenwalze 1 und der Gegenwalze 2 auf die Hinterkante der Druckplatte gegenüber dem Stand der Technik anzusehen.

Bei der weiteren, in Fig. 3 gezeigten Ausführungsform der Erfindung sind die Transportwalzen 3 und 4 gegenüber der Durchlaufebene R, die horizontal zwischen der Bürstenwalze 1 und der Gegenwalze 2 verläuft, vertikal abgesenkt. Dies bedeutet, daß der Einlaufspalt der Transportwalzen 3 und 4, die der Bürstenwalze 1 und der Gegenwalze 2 nachgeordnet sind, unterhalb des Niveaus der Durchlaufebene R liegt. Die Absenkung b der Transportwalzen 3 und 4 wird zwischen 2 bis 4 mm gewählt. Die Absenkung b hängt von dem Abstand zwischen der Bürstenwalze 1 und den Transportwalzen 3 und 4 ab.

Je größer dieser Abstand ist, umso größer wird auch die Absenkung der Transportwalzen 3 und 4 gewählt.

Mit den in den Fig. 2 und 3 schematisch dargestellten Entwicklungsstationen ist eine sichere Verarbeitung von Druckplatten unter weitgehender Vermeidung eines Hochschlagens der Hinterkanten der Druckplatten möglich.

Dadurch ist sichergestellt, daß die Druckplatten während des Transports keinen zusätzlichen mechanischen Schwingungen unterliegen und somit das entwickelte Ladungsbild nicht durch mechanische Einflüsse beschädigt wird. Von Vorteil ist bei der Erfindung, daß mit sehr einfachen konstruktiven Maßnahmen, wie der Versetzung der Gegenwalze gegenüber der Bürstenwalze und gegebenenfalls dem Absenken der Transportwalzen gegenüber der Ebene, die horizontal zwischen dem Ausreibelement und der Gegenwalze verläuft, das Hochschlagen der Hinterkanten der Druckplatten verhindert wird.

In den Zeichnungen sind der Abstand a und die Absenkung b gegenüber den in der Praxis vorgesehenen Walzendurchmessern vergrößert dargestellt.

## Patentansprüche

1. Entwicklungsstation einer Verarbeitungsanlage für Druckplatten, mit zumindest einem Ausreibelement und einer Gegenwalze, sowie in Durchlaufrichtung der Druckplatten dem Ausreibelement nachgeordneten Transportwalzen, dadurch gekennzeichnet, daß das Ausreibelement (1) gegenüber der Gegenwalze (2) in der Durchlaufebene (R) der Druckplatten (7,8) um einen vorgegebenen Abstand (a) in Durchlaufrichtung versetzt ist.

2. Entwicklungsstation einer Verarbeitungsanlage für Druckplatten nach Anspruch 1, dadurch gekennzeichnet, daß die Durchlaufebene (R) horizontal durch den Spalt zwischen dem Ausreibelement (1) und der Gegenwalze (2) und durch den Spalt zwischen den Transportwalzen (3,4) verläuft.

3. Entwicklungsstation einer Verarbeitungsanlage für Druckplatten nach Anspruch 1, dadurch gekennzeichnet, daß das Ausreibelement (1) eine Bürstenwalze ist, daß die Mittelpunkte der Bürstenwalze (1) und der Gegenwalze (2) um den Abstand (a) in Horizontalrichtung gegeneinander versetzt sind und daß die Bürstenwalze (1) und die Gegenwalze (2) einander berühren.

4. Entwicklungsstation einer Verarbeitungsanlage für Druckplatten nach Anspruch 3, dadurch gekennzeichnet, daß der Abstand (a) zwei bis acht Millimeter beträgt.

5. Entwicklungsstation einer Verarbeitungsanlage für Druckplatten nach Anspruch 4, dadurch gekennzeichnet, daß bei einem Außendurchmesser der Bürstenwalze (1) von 70 mm, einer freien Borstenlänge von 10 mm und einem Außendurchmesser von 60 mm der Gegenwalze (2) der Abstand (a) gleich 4 mm ist.

6. Entwicklungsstation einer Verarbeitungsanlage für Druckplatten nach Anspruch 1, dadurch gekennzeichnet, daß die Transportwalzen (3,4) gegenüber der Ebene (R), die horizontal zwischen dem Ausreibelement (1) und der Gegenwalze (2) verläuft, vertikal abgesenkt sind.

7. Entwicklungsstation einer Verarbeitungsanlage für Druckplatten nach Anspruch 6, dadurch gekennzeichnet, daß die Absenkung (b) der Transportwalzen (3,4) zwei bis vier Millimeter beträgt.

## Claims

1. A developing station of a processing system for printing plates, with at least one rubbing element and one counter-roller, as well as transport rollers arranged downstream of the rubbing element in the direction of passage of the printing plates, wherein the rubbing element (1) is offset with respect to the counter-roller (2) in the plane of passage (R) of the printing plates (7, 6) by a given distance (a) in the direction of passage.

2. The developing station of a processing system for printing plates as claimed in claim 1, wherein the plane of passage (R) runs horizontally through the gap between the rubbing element (1) and the counter-roller (2) and through the gap between the transport rollers (3, 4).

3. The developing station of a processing system for printing plates as claimed in claim 1, wherein the rubbing element (1) is a brush roller, wherein the midpoints of the brush roller (1) and of the counter-roller (2) are offset with respect to each other by the distance (a) in horizontal direction and wherein the brush roller (1) and the counterroller (2) touch.

4. The developing station of a processing system for printing plates as claimed in claim 3, wherein the distance (a) is two to eight millimeters.

5. The developing station of a processing system for printing plates as claimed in claim 4, wherein, with an external diameter of the brush roller (1) of 70 mm, a free bristle length of 10 mm and an external diameter of 60 mm of the counter-roller (2), the distance (a) is equal to 4 mm.

6. The developing station of a processing system for printing plates as claimed in claim 1, wherein the transport rollers (3, 4) are vertically lowered with respect to the place (R), which runs horizontally between the rubbing element (1) and the counter-roller (2).

7. The developing station of a processing system for printing plates as claimed in claim 6, wherein the lowering (b) of the transport rollers (3, 4) is two to four millimeters.

## Revendications

1. Poste de développement d'une installation de traitement pour des plaques d'impression, comportant au moins un élément d'enlèvement par frottement et un cylindre antagoniste, ainsi que des cylindres de transport disposés en aval de l'élément d'enlèvement par frottement, dans le sens de déplacement des plaques d'impression, caractérisé en ce que l'élément d'enlèvement par frottement (1) est décalé dans le sens de déplacement, d'une distance prédéterminée (a), par rapport au cylindre antagoniste (2), dans le plan de déplacement (R) des plaques d'impression (7, 8).

2. Poste de développement d'une installation de traitement pour des plaques d'impression selon la revendication 1, caractérisé en ce que le plan de déplacement (R) s'étend horizontalement dans la fente située entre l'élément d'enlèvement par frottement (1) et le cylindre antagoniste (2) et dans la fente située entre les cylindres de transport (3, 4).

3. Poste de développement d'une installation de traitement pour des plaques d'impression selon la revendication 1, caractérisé en ce que l'élément d'enlèvement par frottement (1) est un cylindre à brosse, que les centres du cylindre à brosse (1) et du cylindre antagoniste (2) sont décalés l'un par rapport à l'autre de la distance (a) dans la direction horizontale et que le cylindre à brosse (1) et le cylindre antagoniste (2) sont en contact mutuel.

4. Poste de développement d'une installation de traitement pour des plaques d'impression selon la revendication 3, caractérisé en ce que la distance (a) possède une valeur comprise entre deux et huit millimètres.

5. Poste de développement d'une installation de traitement pour des plaques d'impression selon la revendication 4, caractérisé en ce que, dans le cas d'un diamètre extérieur du cylindre à brosse (1) égal à 70 mm, d'une longueur libre des poils égale à 10 mm et d'un diamètre extérieur du cylindre antagoniste (2) égal à 60 mm, la distance (a) est égale à 4 mm.

6. Poste de développement d'une installation de traitement pour des plaques d'impression selon la revendication 1, caractérisé en ce que les cylindres de transport (3, 4) sont à un niveau vertical inférieur au plan (R), qui s'étend horizontalement entre l'élément d'enlèvement par frottement (1) et le cylindre antagoniste (2).

7. Poste de développement d'une installation de traitement pour des plaques d'impression selon la revendication 6, caractérisé en ce que la valeur d'abaissement (b) des cylindres de transport (3, 4) est comprise entre deux et quatre millimètres.

Fig. 1

Fig. 2

Fig. 3